# EUROPÄISCHE PATENTANMELDUNG

(11) **EP 2 804 307 A2**
(43) Veröffentlichungstag der Anmeldung: **19.11.2014**
(21) Anmeldenummer: 14158698.2
(22) Anmeldetag: 11.03.2014
(51) Int. Cl.: H02M 7/00, H02M 7/487, H01L 23/48

(54) **3-Level-Stromrichterhalbbrücke**

(30) Priorität: 23.04.2013 DE 102013104081
(71) Anmelder: SEMIKRON Elektronik GmbH & Co. KG, 90431 Nürnberg (DE)
(72) Erfinder: Staudt, Ingo, 90439 Nürnberg (DE)

(57) **Zusammenfassung**

Die Erfindung betrifft eine 3-Level-Stromrichterhalbbrücke mit einem ersten Substrat (2) und einem vom ersten Substrat (2) getrennt angeordneten zweiten Substrat (3), wobei die Leistungshalbleiterschalter (T1,T2,T3,T4) und Dioden (D1,D2,D3,D4) der 3-Level-Stromrichterhalbbrücke (1) derart auf ein erstes Substrat (2) und auf ein zweites Substrat (3) aufgeteilt sind, dass beim bevorzugten Betrieb der 3-Level-Stromrichterhalbbrücke (1) mit einem hohen Leistungsfaktor keine oder nur selten Stromkommutierungen zwischen den Leistungshalbleiterschaltern (T1,T2) und Dioden (D1,D3), die auf dem ersten Substrat (2) angeordnet sind und den Leistungshalbleiterschaltern (T3,T4) und Dioden (D2,D4), die auf dem zweiten Substrat (3) angeordnet sind, auftreten. Die Erfindung schafft eine 3-Level Stromrichterhalbbrücke (1) mit reduzierten Schaltüberspannungen.

## Beschreibung

Die Erfindung betrifft eine 3-Level-Stromrichterhalbbrücke.

Ein 3-Level-Stromrichter zeichnet sich gegenüber den weit verbreiteten konventionellen Stromrichtern dadurch aus, dass er, wenn er als Wechselrichter betrieben wird, an seinen wechselspannungsseitigen Lastanschlüssen AC nicht nur wie ein konventioneller Stromrichter eine elektrische Wechselspannung erzeugen kann, deren Spannungswert im Wesentlichen der elektrischen positiven oder negativen elektrischen Spannung der Zwischenkreisspannung Ud entspricht, sondern zusätzlich am wechselspannungsseitigen Lastanschluss AC eine elektrische Spannung erzeugen kann, deren Spannungswert im Wesentlichen der halben elektrischen positiven oder negativen Spannung der Zwischenkreisspannung Ud entspricht.

Hierdurch ist z.B. eine bessere Annährung der von Stromrichter am wechselspannungsseitigen Lastanschluss AC erzeugten Spannung an eine sinusförmige Wechselspannung möglich.

Ein 3-Level-Stromrichter weist dabei mehrere 3-Level-Stromrichterhalbbrücken auf, die zur Realisierung eines 3-Level Stromrichters elektrisch miteinander verschalten sind.

Es ist bei 3-Level-Stromrichtern bekannt alle zur Realisierung eines 3-Level-Stromrichters benötigen Leistungshalbleiterschalter und Dioden auf einem einzelnen Substrat anzuordnen und mittels einer Leiterschicht des Substrats und Bonddrähten miteinander elektrisch leitend zu verbinden. Die realisierbare elektrische Leistung eines 3-Level-Stromrichters bei dem alle zur Realisierung des 3-Level-Stromrichters benötigen Leistungshalbleiterschalter und Dioden auf einem einzelnen Substrat angeordnet sind, ist jedoch, infolge der begrenzten Wärmeableitfähigkeit des einzelnen Substrat, begrenzt.

Weiterhin ist es auch bekannt zur Realisierung von 3-Level-Stromrichtern, insbesondere zur Realisierung von 3-Level-Stromrichtern, welche eine große elektrische Leistung aufweisen, die Leistungshalbleiterschalter und Dioden auf mehreren voneinander getrennten Substraten anzuordnen und die Substrate elektrisch leitend, z.B. mittels elektrischer Leitungen, miteinander zu verbinden. Die auf den Substraten angeordneten Leistungshalbleiterschalter und die Dioden sind dabei elektrisch zu mehreren sogenannten Halbbrückenschaltungen verschalten, die üblicherweise zum Gleich- und Wechselrichten von elektrischen Spannungen und Strömen verwendet werden. Die Substrate sind in der Regel direkt oder indirekt mit einem Kühlkörper verbunden. Die elektrischen Leitungen mit denen die Substrate verbunden sind weisen den Nachteil auf, dass diese eine relativ hohe parasitäre Induktivität aufweisen, was bei Kommutierungsvorgängen hohe Schaltüberspannungen zur Folge hat, die die realisierbare Schaltgeschwindigkeit und Schaltfrequenz der Leistungshalbleiterschalter vermindern.

Aus der EP 1 670 131 A2 ist ein Leistungshalbleitermodul mit verringerten parasitären Induktivitäten bekannt.

Es ist Aufgabe der Erfindung eine 3-Level-Stromrichterhalbbrücke mit reduzierten Schaltüberspannungen zu schaffen.

Diese Aufgabe wird gelöst durch eine 3-Level-Stromrichterhalbbrücke mit einem ersten Substrat und einem vom ersten Substrat getrennt angeordneten zweiten Substrat, wobei das erste Substrat einen ersten Isolierstoffkörper und eine auf dem ersten Isolierstoffkörper angeordnete elektrisch leitende strukturierte erste Leitungsschicht aufweist, wobei die 3-Level-Stromrichterhalbbrücke eine erste Serienschaltungsanordnung, die einen zweiten Leistungshalbleiterschalter und eine dritte Diode, die mit dem zweiten Leistungshalbleiterschalter elektrisch in Serie geschaltet ist, aufweist, wobei auf der strukturierten ersten Leitungsschicht ein erster Leistungshalbleiterschalter, der zweite Leistungshalbleiterschalter, eine erste Diode und die dritte Diode angeordnet sind und mit der strukturierten ersten Leitungsschicht verbunden sind, wobei das zweite Substrat einen zweiten Isolierstoffkörper und eine auf dem zweiten Isolierstoffkörper angeordnete elektrisch leitende strukturierte zweite Leitungsschicht aufweist, wobei die 3-Level-Stromrichterhalbbrücke eine zweite Serienschaltungsanordnung, die einen dritten Leistungshalbleiterschalter und eine zweite Diode, die mit dem dritten Leistungshalbleiterschalter elektrisch in Serie geschaltet ist, aufweist, wobei auf der strukturierten zweiten Leitungsschicht (7b) ein vierter Leistungshalbleiterschalter, der dritte Leistungshalbleiterschalter, eine vierte Diode und die zweite Diode angeordnet sind und mit der strukturierten zweiten Leitungsschicht verbunden sind, wobei der Eingangsanschluss der ersten Serienschaltungsanordnung mit dem Ausgangsanschluss der zweiten Serienschaltungsanordnung elektrisch leitend verbunden ist, und der Ausgangsanschluss der ersten Serienschaltungsanordnung mit dem Eingangsanschluss der zweiten Serienschaltungsanordnung und mit dem zweiten Laststromanschluss des ersten Leistungshalbleiterschalters und mit dem ersten Laststromanschluss des vierten Leistungshalbleiterschalters elektrisch leitend verbunden ist, wobei die erste Diode elektrisch antiparallel zum ersten Leistungshalbleiterschalter geschaltet ist und die vierte Diode elektrisch antiparallel zum vierten Leistungshalbleiterschalter geschaltet ist, wobei ein Mittenanschluss der ersten Serienschaltungsanordnung, welcher elektrisch zwischen dem zweiten Leistungshalbleiterschalter und der dritten Diode angeordnet ist und ein Mittenanschluss der zweiten Serienschaltungsanordnung, welcher elektrisch zwischen dem dritten Leistungshalbleiterschalter und der zweiten Diode angeordnet ist, elektrisch leitend miteinander verbunden sind, und/oder auf der strukturierten ersten Leitungsschicht eine elektrisch antiparallel zum zweiten Leistungshalbleiterschalter geschaltete fünfte Diode angeordnet ist und mit der strukturierten ersten Leitungsschicht verbunden ist und auf der strukturierten zweiten Leitungsschicht eine elektrisch antiparallel zum dritten Leistungshalbleiterschalter geschaltete sechste Diode angeordnet ist und mit der strukturierten zweiten Leitungsschicht verbunden ist.

Vorteilhafte Ausbildungen der Erfindung ergeben sich aus den abhängigen Ansprüchen.

Es erweist sich als vorteilhaft, wenn der Eingangsanschluss der ersten Serienschaltungsanordnung in Form des ersten Laststromanschlusses des zweiten Leistungshalbleiterschalters und der Ausgangsanschluss der ersten Serienschaltungsanordnung in Form der Kathode der dritten Diode vorliegt, wobei der Eingangsanschluss der zweiten Serienschaltungsanordnung in Form des ersten Laststromanschlusses des dritten Leistungshalbleiterschalters und der Ausgangsanschluss der zweiten Serienschaltungsanordnung in Form der Kathode der zweiten Diode vorliegt. Hierdurch wird eine besonders einfache Ausbildung der ersten und zweiten Serienschaltungsanordnung geschaffen.

Weiterhin erweist es sich als vorteilhaft, wenn der Eingangsanschluss der ersten Serienschaltungsanordnung in Form der Anode der dritten Diode und der Ausgangsanschluss der ersten Serienschaltungsanordnung in Form des zweiten Laststromanschlusses des zweiten Leistungshalbleiterschalters vorliegt, wobei der Eingangsanschluss der zweiten Serienschaltungsanordnung in Form der Anode der zweiten Diode und der Ausgangsanschluss der zweiten Serienschaltungsanordnung in Form des zweiten Laststromanschlusses des dritten Leistungshalbleiterschalters vorliegt. Hierdurch wird eine besonders einfache Ausbildung der ersten und zweiten Serienschaltungsanordnung geschaffen.

Ausführungsbeispiele der Erfindung sind in den Figuren dargestellt und werden im Folgenden näher erläutert. Dabei zeigen:
- FIG 1: ein elektrisches Schaltbild einer techniküblichen 3-Level-Stromrichterhalbbrücke,
- FIG 2: ein elektrisches Schaltbild einer erfindungsgemäßen 3-Level-Stromrichtershalbbrücke und die erfindungsgemäße Aufteilung der Leistungshalbleiterschalter und der Dioden der erfindungsgemäßen 3-Level-Stromrichterhalbbrücke auf ein erstes und ein zweites Substrat,
- FIG 3: ein erstes Substrat einer erfindungsgemäßen 3-Level-Stromrichterhalbbrücke und den auf dem ersten Substrat angeordneten Leistungshalbleiterschalter und Dioden in Form einer schematisierten Darstellung,
- FIG 4: ein zweites Substrat einer erfindungsgemäßen 3-Level-Stromrichterhalbbrücke und den auf dem zweiten Substrat angeordneten Leistungshalbleiterschalter und Dioden in Form einer schematisierten Darstellung,
- FIG 5: ein elektrisches Schaltbild einer weiteren erfindungsgemäßen 3-Level-Stromrichterhalbbrücke und die erfindungsgemäße Aufteilung der Leistungshalbleiterschalter und der Dioden der weiteren erfindungsgemäßen 3-Level-Stromrichterhalbbrücke auf ein erstes und ein zweites Substrat,
- FIG 6: ein elektrisches Schaltbild einer weiteren erfindungsgemäßen 3-Level-Stromrichterhalbbrücke und die erfindungsgemäße Aufteilung der Leistungshalbleiterschalter und der Dioden der weiteren erfindungsgemäßen 3-Level-Stromrichterhalbbrücke auf ein erstes und ein zweites Substrat und
- FIG 7: ein elektrisches Schaltbild einer weiteren erfindungsgemäßen 3-Level-Stromrichterhalbbrücke und die erfindungsgemäße Aufteilung der Leistungshalbleiterschalter und der Dioden der weiteren erfindungsgemäßen 3-Level-Stromrichterhalbbrücke auf ein erstes und ein zweites Substrat.

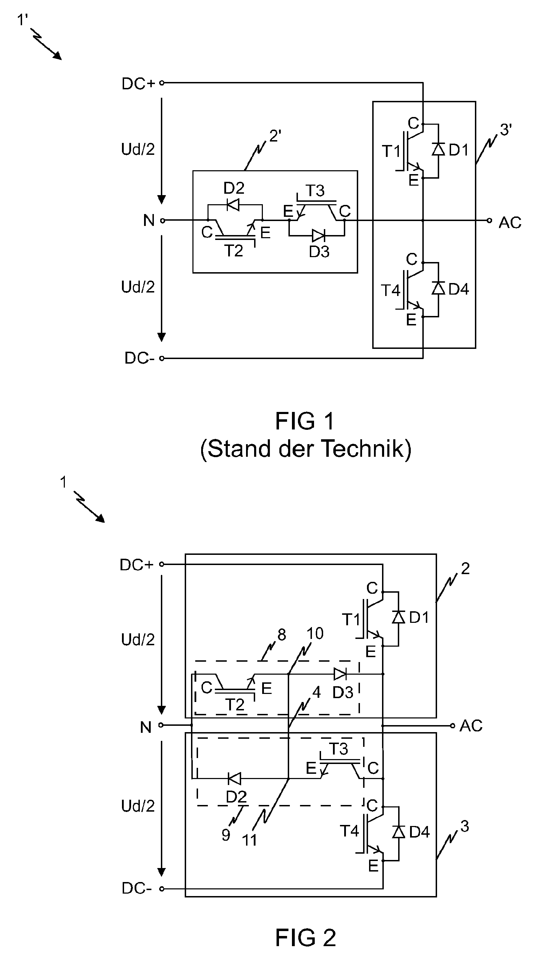

In FIG 1 ist das elektrische Schaltbild einer techniküblichen 3-Level-Stromrichterhalbbrücke 1' dargestellt. Die 3-Level-Stromrichterhalbbrücke 1' weist dabei eine T-Schaltungstopologie auf. Die 3-Level-Stromrichterhalbbrücke 1' weist einen ersten Leistungshalbleiterschalter T1, einen zweiten Leistungshalbleiterschalter T2, einen dritten Leistungshalbleiterschalter T3, einen vierten Leistungshalbleiterschalter T4, eine erste Diode D1, eine zweite Diode D2, eine dritte Diode D3, und eine vierte Diode D4 auf, die elektrisch, wie in FIG 1 dargestellt, zu einer sogenannten Halbbrückenschaltung verschalten sind. Die technikübliche 3-Level-Stromrichterhalbbrücke 1' weist ein erstes Substrat 2' und einem vom ersten Substrat 2' getrennt angeordnetes zweites Substrat 3' auf, wobei der zweite und dritte Leistungshalbleiterschalter T2 und T3 und die zweite und dritte Diode D2 und D3 auf dem ersten Substrat 2' angeordnet sind, und der erste und vierte Leistungshalbleiterschalter T1 und T4 und die erste und vierte Diode D1 und D4 auf dem zweiten Substrat 3' angeordnet sind. Die 3-Level-Stromrichterhalbbrücke 1' wird von zwei in FIG 1 nicht dargestellten Spannungsquellen gespeist, die jeweilig die halbe Zwischenkreisspannung Ud/2 erzeugen, so das zwischen den beiden Gleichspannnungsanschlüssen DC+ und DC- die Zwischenkreisspannung Ud anliegt. Der Neutralanschluss der 3-Level-Stromrichterhalbbrücke 1' ist in FIG 1 mit N bezeichnet.

In FIG 1 sind die Leistungshalbleiterschalter als IGBT ausgebildet und können über Ihren Steuereingang ein- und ausgeschaltet werden. Durch entsprechendes Ein- und Ausschalten der Leistungshalbleiterschalter können am wechselspannungsseitigen Lastanschluss AC elektrische Spannungen erzeugt werden, deren Spannungsbetragswert im Wesentlichen der elektrischen Spannung der Zwischenkreisspannung Ud oder im Wesentlichen der halben elektrischen Zwischenkreisspannung Ud/2 entsprechen, so dass bei entsprechender Ansteuerung der Leistungshalbleiterschalter entsprechende Spannungen am wechselspannungsseitigen Lastanschluss AC aus den beiden halben Zwischenkreisspannung Ud/2 bzw. aus der Zwischenkreisspannung Ud erzeugt werden. Die elektrische Funktionsweise eines 3-Level-Stromrichters ist allgemein bekannter Stand der Technik.

Es sei angemerkt, dass ein 3-Level-Stromrichter mehrere 3-Level-Stromrichterhalbbrücken aufweist. So kann der 3-Level-Stromrichter z.B. drei 3-Level-Stromrichterhalbbrücken aufweisen mittels derer, durch entsprechende Ansteuerung der Leistungshalbleiterschalter der 3-Level-Stromrichterhalbbrücken, aus den beiden halben Zwischenkreisspannung Ud/2 bzw. der Zwischenkreisspannung Ud eine 3-phasige Wechselspannung, z.B. zur Ansteuerung eines Elektromotors, erzeugt werden kann. Selbstverständlich kann ein 3-Level-Stromrichter aber auch als Gleichrichter arbeiten.

Beim allgemeinen Betrieb einer 3-Level-Stromrichterhalbbrücke gemäß FIG 1 treten beim Ein- und Ausschalten der Leistungshalbleiterschalter beim bevorzugten Betrieb mit einem hohen Leistungsfaktor (hoher Wirkleistungsanteil) hauptsächlich Stromkommutierungen zwischen einer ersten Schaltungsanordnung, bestehend aus dem zweiten Leistungshalbleiterschalter T2, der dritten Diode D3 und dem ersten Leistungshalbleiterschalter T1, und einer zweiten Schaltungsanordnung, bestehend aus dem dritten Leistungshalbleiterschalter T3, der zweiten Diode D2 und dem vierten Leistungshalbleiterschalter T4, auf.

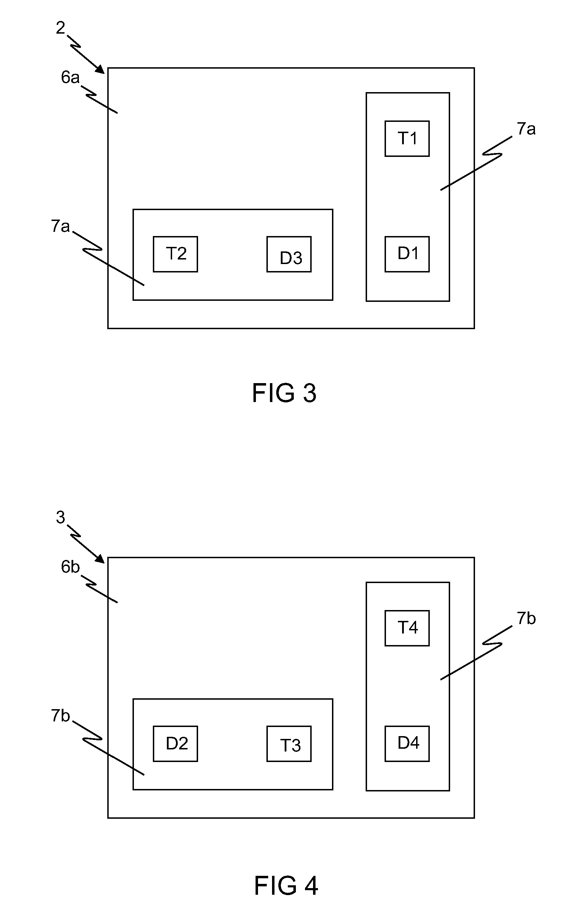

Diese technische Erkenntnis wird zur Realisierung einer erfindungsgemäßen 3-Level-Stromrichterhalbbrücke verwendet. In FIG 2 ist ein elektrisches Schaltbild einer erfindungsgemäßen 3-Level-Stromrichterhalbbrücke 1 und die erfindungsgemäße Aufteilung der Leistungshalbleiterschalter und der Dioden der erfindungsgemäßen 3-Level-Stromrichterhalbbrücke 1 auf ein erstes Substrat 2 und ein zweites Substrat 3 dargestellt. In FIG 3 ist das erste Substrat 2 des erfindungsgemäßen 3-Level-Stromrichters 1 und der auf dem ersten Substrat 2 angeordneten Leistungshalbleiterschalter und Dioden in Form einer schematisierten Darstellung dargestellt. In FIG 4 ist das zweite Substrat 3 der erfindungsgemäßen 3-Level-Stromrichterhalbbrücke 1 und der auf dem zweiten Substrat 3 angeordneten Leistungshalbleiterschalter und Dioden in Form einer schematisierten Darstellung dargestellt. Die 3-Level-Stromrichterhalbbrücke 1 weist dabei eine T-Schaltungstopologie auf. Der Neutralanschluss der 3-Level-Stromrichterhalbbrücke 1 ist in FIG 2 bis FIG 7 mit N bezeichnet.

Erfindungsgemäß sind die Leistungshalbleiterschalter und Dioden der erfindungsgemäßen 3-Level-Stromrichterhalbbrücke 1 derart auf ein erstes Substrat 2 und auf ein zweites Substrat 3 aufgeteilt, dass beim bevorzugten Betrieb der 3-Level-Stromrichterhalbbrücke 1 mit einem hohen Leistungsfaktor (hoher Wirkleistungsanteil) keine oder nur selten Stromkommutierungen zwischen den Leistungshalbleiterschaltern und Dioden, die auf dem ersten Substrat 2 angeordnet sind und den Leistungshalbleiterschaltern und Dioden, die auf dem zweiten Substrat 3 angeordnet sind, auftreten. Dadurch ist die Bedeutung der parasitären Induktivitäten der elektrischen Verbindungsleitungen, welche das erste und das zweite Substrat 2 und 3 elektrisch leitend miteinander verbinden deutlich reduziert und infolge dessen sind die Schaltüberspannungen bei der erfindungsgemäßen 3-Level Stromrichterhalbbrücke 1 gegenüber techniküblichen 3-Level Stromrichterhalbbrücken, bei denen die Leistungshalbleiterschalter und Dioden in anderer Form auf mehrere Substrate verteilt sind, deutlich reduziert.

Wie schon beschrieben weist die erfindungsgemäße 3-Level Stromrichterhalbbrücke 1 ein erstes Substrat 2 und ein vom ersten Substrat 2 getrennt angeordnetes zweites Substrat 3 auf. Das erste und das zweite Substrat 2 und 3 können in einem gemeinsamen Gehäuse oder in zwei voneinander getrennten Gehäusen angeordnet sein. Das erste Substrat 2 weist einen ersten Isolierstoffkörper 6a und eine auf dem ersten Isolierstoffkörper 6a angeordnete elektrisch leitende strukturierte erste Leitungsschicht auf, die infolge ihrer Struktur elektrische Leiterbahnen 7a ausbildet. Vorzugsweise weist das erste Substrat 2 eine weitere elektrisch leitende, vorzugsweise unstrukturierte Leitungsschicht auf, wobei der Isolierstoffkörper 6a zwischen der strukturierten ersten Leitungsschicht und der weiteren Leitungsschicht angeordnet ist. An der weiteren Leitungsschicht des ersten Substrats 2 ist im Allgemeinen ein Kühlkörper, der zur Kühlung der auf dem ersten Substrat 2 angeordneten Elemente dient, angeordnet. Die weitere Leitungsschicht des ersten Substrats 2 ist in der in FIG 3 dargestellten Ansicht nicht sichtbar auf der Rückseite des ersten Isolierstoffkörpers 6a angeordnet. Die strukturierte erste Leitungsschicht des ersten Substrats 2 kann z.B. aus Kupfer bestehen. Die strukturierte erste Leitungsschicht des ersten Substrats 2 kann aber auch einen mehrschichtigen Aufbau aufweisen (z.B. Kupferschicht mit einer metallischen Oberflächenbeschichtung). Das erste Substrat kann z.B. in Form eines DCB-Substrats oder in Form eines Insulated Metal Substrats vorliegen. Im Falle eines DCB-Substrat kann der erste Isolierstoffkörper 6a z.B. aus einer Keramik bestehen und die weitere Leitungsschicht des ersten Substrats aus Kupfer bestehen. Im Falle eines Insulated Metal Substrats kann der erste Isolierstoffkörper z.B. aus einer Schicht aus Polyimid oder Epoxy bestehen und die weitere Leitungsschicht des ersten Substrats aus einem Metallformkörper bestehen. Der Metallformkörper kann z.B. aus Aluminium oder einer Aluminiumlegierung bestehen.

Das zweite Substrat 3 weist einen zweiten Isolierstoffkörper 6b und eine auf dem zweiten Isolierstoffkörper 6b angeordnete elektrisch leitende strukturierte zweite Leitungsschicht auf, die infolge ihrer Struktur elektrische Leiterbahnen 7b ausbildet Vorzugsweise weist das zweite Substrat 3 eine weitere elektrisch leitende, vorzugsweise unstrukturierte Leitungsschicht auf, wobei der Isolierstoffkörper 6b zwischen der strukturierten ersten Leitungsschicht und der weiteren Leitungsschicht angeordnet ist. An der weiteren Leitungsschicht des zweiten Substrats 3 ist im Allgemeinen ein Kühlkörper, der zur Kühlung der auf dem zweiten Substrat 3 angeordneten Elemente dient, angeordnet. Die weitere Leitungsschicht des zweiten Substrats 3 ist in der in FIG 3 dargestellten Ansicht nicht sichtbar auf der Rückseite des zweiten Isolierstoffkörpers 6b angeordnet. Die strukturierte zweite Leitungsschicht des zweiten Substrats 3 kann z.B. aus Kupfer bestehen. Die strukturierte zweite Leitungsschicht des zweiten Substrats 3 kann auch einen mehrschichtigen Aufbau aufweisen (z.B. Kupferschicht mit einer metallischen Oberflächenbeschichtung). Das zweite Substrat kann z.B. in Form eines DCB-Substrats oder in Form eines Insulated Metal Substrats vorliegen. Im Falle eines DCB-Substrat kann der zweite Isolierstoffkörper 6b z.B. aus einer Keramik bestehen und die weitere Leitungsschicht des zweiten Substrats aus Kupfer bestehen. Im Falle eines Insulated Metal Substrats kann der zweite Isolierstoffkörper 6b z.B. aus einer Schicht aus Polyimid oder Epoxy bestehen und die weitere Leitungsschicht des zweiten Substrats aus einem Metallformkörper bestehen. Der Metallformkörper kann z.B. aus Aluminium oder einer Aluminiumlegierung bestehen.

Die 3-Level-Stromrichterhalbbrücke 1 weist eine erste Serienschaltungsanordnung 8 auf, die einen zweiten Leistungshalbleiterschalter T2 und eine dritte Diode D3, die mit dem zweiten Leistungshalbleiterschalter T2 elektrisch in Serie geschaltet ist, aufweist, wobei auf der strukturierten ersten Leitungsschicht 7a ein erster Leistungshalbleiterschalter T1, der zweite Leistungshalbleiterschalter T2, eine erste Diode D1 und die dritte Diode D3 angeordnet sind und mit der strukturierten ersten Leitungsschicht 7a verbunden sind.

Weiterhin weist die 3-Level-Stromrichterhalbbrücke 1 einen zweite Serienschaltungsanordnung 9 auf, die einen dritten Leistungshalbleiterschalter T3 und eine zweite Diode D2, die mit dem dritten Leistungshalbleiterschalter T3 elektrisch in Serie geschaltet ist, aufweist, wobei auf der strukturierten zweiten Leitungsschicht 7b ein vierter Leistungshalbleiterschalter T4, der dritte Leistungshalbleiterschalter T3, eine vierte Diode D4 und die zweite Diode D2 angeordnet sind und mit der strukturierten zweiten Leitungsschicht 7b verbunden sind.

Der Eingangsanschluss der ersten Serienschaltungsanordnung 8 ist mit dem Ausgangsanschluss der zweiten Serienschaltungsanordnung 9 elektrisch leitend verbunden, wobei im Rahmen des Ausführungsbeispiels der Eingangsanschluss der ersten Serienschaltungsanordnung 8 in Form des ersten Laststromanschlusses C des zweiten Leistungshalbleiterschalter T2 vorliegt und der Ausgangsanschluss der zweiten Serienschaltungsanordnung 9 in Form der Kathode der zweiten Diode D2 vorliegt.

Der Ausgangsanschluss der ersten Serienschaltungsanordnung 8 ist mit dem Eingangsanschluss der zweiten Serienschaltungsanordnung 9 und mit dem zweiten Laststromanschluss E des ersten Leistungshalbleiterschalters T1 und mit dem ersten Laststromanschluss C des vierten Leistungshalbleiterschalter T4 elektrisch leitend verbunden, wobei im Rahmen des Ausführungsbeispiels der Ausgangsanschluss der ersten Serienschaltungsanordnung 8 in Form der Kathode der dritten Diode D3 vorliegt und der Eingangsanschluss der zweiten Serienschaltungsanordnung 9 in Form des ersten Laststromanschluss C des dritten Leistungshalbleiterschalter T3 vorliegt.

Die erste Diode D1 ist elektrisch antiparallel zum ersten Leistungshalbleiterschalter T1 geschaltet ist und die vierte Diode D4 ist elektrisch antiparallel zum vierten Leistungshalbleiterschalter T4 geschaltet, wobei solchermaßen beim Ausführungsbeispiel die Anode der ersten Diode D1 elektrisch leitend mit dem zweiten Laststromanschluss E des ersten Leistungshalbleiterschalters T1 und die Kathode der ersten Diode D1 elektrisch leitend mit dem ersten Laststromanschluss C des ersten Leistungshalbleiterschalters T1 verbunden ist, und die Anode der vierten Diode D4 elektrisch leitend mit dem zweiten Laststromanschluss E des vierten Leistungshalbleiterschalters T4 und die Kathode der vierten Diode D4 elektrisch leitend mit dem ersten Laststromanschluss C des vierten Leistungshalbleiterschalters T4 verbunden ist.

Die erste Serienschaltungsanordnung 8 weist einen Mittenanschluss 10 auf, der elektrisch zwischen dem zweiten Leistungshalbleiterschalter T2 und der dritten Diode D3 angeordnet ist und solchermaßen beim Ausführungsbeispiel mit dem zweiten Laststromanschluss E des zweiten Leistungshalbleiterschalters T2 und mit der Anode der dritten Diode D3 elektrisch leitend verbunden ist. Die zweite Serienschaltungsanordnung 9 weist einen Mittenanschluss 11 auf, der elektrisch zwischen dem dritten Leistungshalbleiterschalter T3 und der zweiten Diode D2 angeordnet ist und solchermaßen beim Ausführungsbeispiel mit dem zweiten Laststromanschluss E des dritten Leistungshalbleiterschalters T3 und mit der Anode der zweiten Diode D2 elektrisch leitend verbunden ist. Beim Ausführungsbeispiel der Erfindung gemäß FIG 2 ist der Mittenanschluss 10 der ersten Serienschaltungsanordnung 8 mit dem Mittenanschluss 11 der zweiten Serienschaltungsanordnung 9 mittels einer elektrisch leitenden Verbindung 4 elektrisch leitend miteinander verbunden. Die elektrisch leitende Verbindung 4 verläuft dabei vom ersten Substrat 2 zum zweiten Substrat 3. Dadurch, dass der Mittenanschluss 10 der ersten Serienschaltungsanordnung 8 mit dem Mittenanschluss 11 der zweiten Serienschaltungsanordnung 9 elektrisch leitend verbunden ist, kann auf eine fünften Diode, die elektrisch antiparallel zum zweiten Leistungshalbleiterschalter T2 geschaltet ist und auf eine sechste Diode, die elektrisch antiparallel zum dritten Leistungshalbleiterschalter T3 geschaltet ist, verzichtet werden. Im Rahmen des Ausführungsbeispiels ist zum zweiten Leistungshalbleiterschalter T2 und zum dritten Leistungshalbleiterschalter T3 keine Diode elektrisch antiparallel geschaltet. Die 3-Level-Stromrichterhalbbrücke 1 gemäß FIG 2 weist somit eine besonders geringe Anzahl von elektrischen Bauelementen auf.

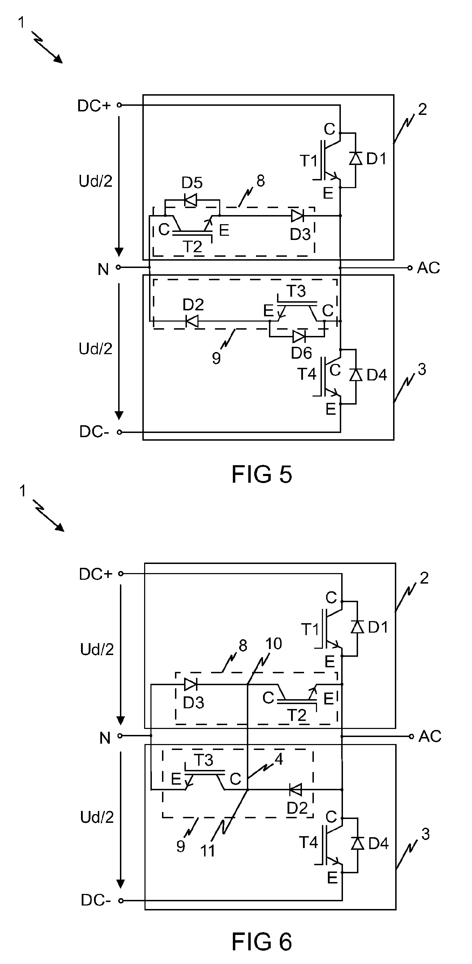

In FIG 5 ist ein elektrisches Schaltbild einer weiteren erfindungsgemäßen 3-Level-Stromrichterhalbbrücke 1 dargestellt, die mit der 3-Level-Stromrichterhalbbrücke 1 gemäß FIG 2 bis auf das Merkmal, dass bei der 3-Level-Stromrichterhalbbrücke 1 gemäß FIG 5 auf der strukturierten ersten Leitungsschicht eine elektrisch antiparallel zum zweiten Leistungshalbleiterschalter T2 geschaltete fünfte Diode D5 angeordnet ist und mit der strukturierten ersten Leitungsschicht verbunden ist und auf der strukturierten zweiten Leitungsschicht eine elektrisch antiparallel zum dritten Leistungshalbleiterschalter T3 geschaltete sechste Diode D6 angeordnet ist und mit der strukturierten zweiten Leitungsschicht verbunden ist, und der Mittenanschluss 10 der ersten Serienschaltungsanordnung 8 nicht mit dem Mittenanschluss 11 der zweiten Serienschaltungsanordnung 9 elektrisch leitend verbunden ist, übereinstimmt. Die 3-Level-Stromrichterhalbbrücke 1 gemäß FIG 5 weist gegenüber der 3-Level-Stromrichterhalbbrücke 1 gemäß FIG 2 den Vorteil auf, dass auf die substartübergreifende elektrisch leitende Verbindung 4 verzichtet werden kann.

In FIG 6 ist ein elektrisches Schaltbild einer weiteren erfindungsgemäßen 3-Level-Stromrichterhalbbrücke 1 dargestellt, die mit der 3-Level-Stromrichterhalbbrücke 1 gemäß FIG 2 bis auf das Merkmal, dass bei der 3-Level-Stromrichterhalbbrücke 1 gemäß FIG 6 der Eingangsanschluss der ersten Serienschaltungsanordnung 8 in Form der Anode der dritten Diode D3 und der Ausgangsanschluss der ersten Serienschaltungsanordnung 8 in Form des zweiten Laststromanschlusses E des zweiten Leistungshalbleiterschalters T2 vorliegt, wobei der Eingangsanschluss der zweiten Serienschaltungsanordnung 9 in Form der Anode der zweiten Diode D2 und der Ausgangsanschluss der zweiten Serienschaltungsanordnung 9 in Form des zweiten Laststromanschlusses E des dritten Leistungshalbleiterschalters T3 vorliegt, übereinstimmt. Der Mittenanschluss 10 der ersten Serienschaltungsanordnung 8, der elektrisch zwischen dem zweiten Leistungshalbleiterschalter T2 und der dritten Diode D3 angeordnet ist, ist solchermaßen bei diesem Ausführungsbeispiel mit dem ersten Laststromanschluss C des zweiten Leistungshalbleiterschalters T2 und mit der Kathode der dritten Diode D3 elektrisch leitend verbunden und der Mittenanschluss 11 der zweiten Serienschaltungsanordnung 9, der elektrisch zwischen dem dritten Leistungshalbleiterschalter T3 und der zweiten Diode D2 angeordnet ist, ist solchermaßen bei diesem Ausführungsbeispiel mit dem ersten Laststromanschluss C des dritten Leistungshalbleiterschalters T3 und mit der Kathode der zweiten Diode D2 elektrisch leitend verbunden.

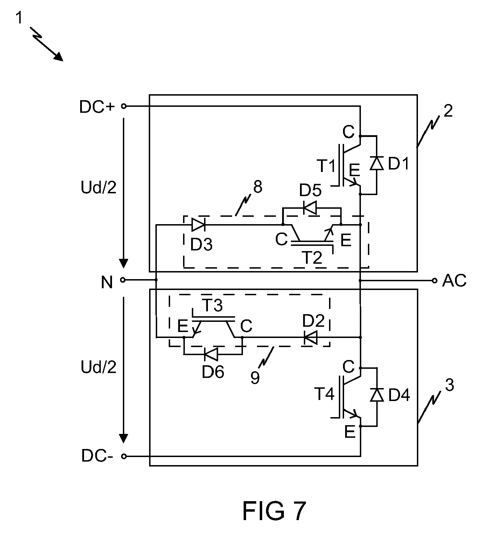

In FIG 7 ist ein elektrisches Schaltbild einer weiteren erfindungsgemäßen 3-Level-Stromrichterhalbbrücke 1 dargestellt, die mit der 3-Level-Stromrichterhalbbrücke 1 gemäß FIG 5 bis auf das Merkmal, dass bei der 3-Level-Stromrichterhalbbrücke 1 gemäß FIG 7 der Eingangsanschluss der ersten Serienschaltungsanordnung 8 in Form der Anode der dritten Diode D3 und der Ausgangsanschluss der ersten Serienschaltungsanordnung 8 in Form des zweiten Laststromanschlusses E des zweiten Leistungshalbleiterschalters T2 vorliegt, wobei der Eingangsanschluss der zweiten Serienschaltungsanordnung 9 in Form der Anode der zweiten Diode D2 und der Ausgangsanschluss der zweiten Serienschaltungsanordnung 9 in Form des zweiten Laststromanschlusses E des dritten Leistungshalbleiterschalters T3 vorliegt, übereinstimmt.

Es sei an dieser Stelle angemerkt, dass die in FIG 2 und FIG 5 dargestellten Ausführungsbeispiele auch miteinander kombiniert werden können. Weiterhin können auch die in FIG 6 und FIG 7 dargestellten Ausführungsbeispiele miteinander kombiniert werden. In diesem Fall ist die erste Diode D1 elektrisch antiparallel zum ersten Leistungshalbleiterschalter T1 geschaltet und die vierte Diode D4 elektrisch antiparallel zum vierten Leistungshalbleiterschalter T4 geschaltet, wobei der Mittenanschluss 10 der ersten Serienschaltungsanordnung 8, welcher elektrisch zwischen dem zweiten Leistungshalbleiterschalter T2 und der dritten Diode D3 angeordnet ist und der Mittenanschluss 11 der zweiten Serienschaltungsanordnung 9, welcher elektrisch zwischen dem dritten Leistungshalbleiterschalter T3 und der zweiten Diode D2 angeordnet ist, elektrisch leitend miteinander verbunden sind, und auf der strukturierten ersten Leitungsschicht 7a eine elektrisch antiparallel zum zweiten Leistungshalbleiterschalter T2 geschaltete fünfte Diode D5 angeordnet ist und mit der strukturierten ersten Leitungsschicht 7a verbunden ist und auf der strukturierten zweiten Leitungsschicht 7b eine elektrisch antiparallel zum dritten Leistungshalbleiterschalter T3 geschaltete sechste Diode D6 angeordnet ist und mit der strukturierten zweiten Leitungsschicht 7b verbunden ist. In diesem Fall wird der Laststrom zwischen den elektrisch parallel geschalteten zweiten und fünften Dioden D2 und D5, bzw. zwischen den elektrisch parallel geschalteten dritten und sechsten Dioden D3 und D6 aufgeteilt. Dieses Ausführungsbeispiel hat den Vorteil, dass die elektrische Leistung für die die zweite und dritte Diode ausgelegt sein müssen, reduziert werden kann und somit kleinere Dioden als zweite und dritte Diode verwendet werden können.

Im Rahmen der Ausführungsbeispiele weisen die jeweiligen Leistungshalbleiterschalter bzw. Dioden auf Ihrer dem ersten bzw. dem zweiten Substrat zugewandten Seite einen elektrischen Laststromanschluss auf, der z.B. über eine Löt- oder Sinterverbindung mit einer jeweilig zugeordneten Leiterbahn des Substrats verbunden ist und an ihrer dem ersten bzw. dem zweiten Substrat abgewandten Seite einen elektrischen Laststromanschluss auf, der beim Ausführungsbeispiel über Bonddrähte mit einer jeweilig zugeordneten Leiterbahn verbunden ist. Der Übersichtlichkeit sind in FIG 3 und FIG 4 die Bonddrähte nicht dargestellt und nur die Wesentlichen Leiterbahnen dargestellt. Anstatt über Bonddrähte können die betreffenden Elemente auch über andere elektrische Verbindungsmittel miteinander elektrisch leitend verbunden sein. Weiterhin sind der Übersichtlichkeit halber auch die elektrisch leitenden Verbindungen zwischen dem ersten und zweiten Substrat in FIG 3 und FIG 4 nicht dargestellt.

Die Leistungshalbleiterschalter liegen im Allgemeinen in Form von Transistoren, wie z.B. IGBTs (Insulated Gate Bipolar Transistor) oder MOSFETs (Metal Oxide Semiconductor Field Effect Transistor), oder in Form von gesteuert ausschaltbaren Thyristoren vor, wobei im Rahmen des Ausführungsbeispiels die Leistungshalbleiterschalter in Form von IGBTs vorliegen und der erste Laststromanschluss C des jeweiligen Leistungshalbleiterschalters in Form des Kollektors des jeweiligen IGBT und der zweite Laststromanschluss E des jeweiligen Leistungshalbleiterschalters in Form des Emitters des jeweiligen IGBT vorliegt. Der Steueranschluss der Leistungshalbleiterschalter ist der Übersichtlichkeit halber in FIG 3 und FIG 4 nicht dargestellt und liegt beim Ausführungsbeispiels in Form des Gate des jeweiligen IGBT vor.

Es sei an dieser Stelle weiterhin angemerkt, dass im Sinne der vorliegenden Erfindung unter dem Ausdruck, dass zwei Elemente elektrisch leitend verbunden sind, sowohl eine direkte elektrisch leitende Verbindung von zwei Elementen, mittels z.B. einer Schweiß-, Löt- oder Sinterverbindung, die zwischen den beiden Elementen besteht, als auch eine indirekte elektrisch leitende Verbindung, mittels z.B. einem oder mehreren Leitungselementen, wie z.B. einer Leiterbahn, einem Bonddraht, einem elektrisch leitenden Folienverbund, einer Stromschiene oder einem Kabel, die die beiden Elemente elektrisch miteinander verbinden, so dass ein bidirektionaler elektrischer Stromfluss zwischen den beiden elektrisch miteinander leitend verbunden Elementen möglich ist, verstanden wird.

Weiterhin sei angemerkt, dass gegebenenfalls zur Erhöhung der Stromtragefähigkeit der erfindungsgemäßen 3-Level-Stromrichterhalbbrücke den jeweiligen Leistungshalbleiterschaltern noch ein oder mehrere Leistungshalbleiterschalter elektrisch parallel geschaltet sein können und den jeweiligen Dioden noch ein oder mehrere Dioden elektrisch parallel geschaltet sein können.

## Patentansprüche

1. 3-Level-Stromrichterhalbbrücke mit einem ersten Substrat (2) und einem vom ersten Substrat (2) getrennt angeordneten zweiten Substrat (3),
wobei das erste Substrat (2) einen ersten Isolierstoffkörper (6a) und eine auf dem ersten Isolierstoffkörper (6a) angeordnete elektrisch leitende strukturierte erste Leitungsschicht (7a) aufweist, wobei die 3-Level-Stromrichterhalbbrücke (1) eine erste Serienschaltungsanordnung (8), die einen zweiten Leistungshalbleiterschalter (T2) und eine dritte Diode (D3), die mit dem zweiten Leistungshalbleiterschalter (T2) elektrisch in Serie geschaltet ist, aufweist, wobei auf der strukturierten ersten Leitungsschicht (7a) ein erster Leistungshalbleiterschalter (T1), der zweite Leistungshalbleiterschalter (T2), eine erste Diode (D1) und die dritte Diode (D3) angeordnet sind und mit der strukturierten ersten Leitungsschicht (7a) verbunden sind,
wobei das zweite Substrat (3) einen zweiten Isolierstoffkörper (6b) und eine auf dem zweiten Isolierstoffkörper (6b) angeordnete elektrisch leitende strukturierte zweite Leitungsschicht (7b) aufweist, wobei die 3-Level-Stromrichterhalbbrücke (1) eine zweite Serienschaltungsanordnung (9), die einen dritten Leistungshalbleiterschalter (T3) und eine zweite Diode (D2), die mit dem dritten Leistungshalbleiterschalter (T3) elektrisch in Serie geschaltet ist, aufweist, wobei auf der strukturierten zweiten Leitungsschicht (7b) ein vierter Leistungshalbleiterschalter (T4), der dritte Leistungshalbleiterschalter (T3), eine vierte Diode (D4) und die zweite Diode (D2) angeordnet sind und mit der strukturierten zweiten Leitungsschicht (7b) verbunden sind,
wobei der Eingangsanschluss der ersten Serienschaltungsanordnung (8) mit dem Ausgangsanschluss der zweiten Serienschaltungsanordnung (9) elektrisch leitend verbunden ist, und der Ausgangsanschluss der ersten Serienschaltungsanordnung (8) mit dem Eingangsanschluss der zweiten Serienschaltungsanordnung (9) und mit dem zweiten Laststromanschluss (E) des ersten Leistungshalbleiterschalters (T1) und mit dem ersten Laststromanschluss (C) des vierten Leistungshalbleiterschalters (T4) elektrisch leitend verbunden ist,
wobei die erste Diode (D1) elektrisch antiparallel zum ersten Leistungshalbleiterschalter (T1) geschaltet ist und die vierte Diode (D4) elektrisch antiparallel zum vierten Leistungshalbleiterschalter (T4) geschaltet ist, wobei ein Mittenanschluss (10) der ersten Serienschaltungsanordnung (8), welcher elektrisch zwischen dem zweiten Leistungshalbleiterschalter (T2) und der dritten Diode (D3) angeordnet ist und ein Mittenanschluss (11) der zweiten Serienschaltungsanordnung (9), welcher elektrisch zwischen dem dritten Leistungshalbleiterschalter (T3) und der zweiten Diode (D2) angeordnet ist, elektrisch leitend miteinander verbunden sind, und/oder auf der strukturierten ersten Leitungsschicht (7a) eine elektrisch antiparallel zum zweiten Leistungshalbleiterschalter (T2) geschaltete fünfte Diode (D5) angeordnet ist und mit der strukturierten ersten Leitungsschicht (7a) verbunden ist und auf der strukturierten zweiten Leitungsschicht (7b) eine elektrisch antiparallel zum dritten Leistungshalbleiterschalter (T3) geschaltete sechste Diode (D6) angeordnet ist und mit der strukturierten zweiten Leitungsschicht (7b) verbunden ist.

2. 3-Level-Stromrichterhalbbrücke nach Anspruch 1, **dadurch gekennzeichnet, dass** der Eingangsanschluss der ersten Serienschaltungsanordnung (8) in Form des ersten Laststromanschlusses (C) des zweiten Leistungshalbleiterschalters (T2) und der Ausgangsanschluss der ersten Serienschaltungsanordnung (8) in Form der Kathode der dritten Diode (D3) vorliegt, wobei der Eingangsanschluss der zweiten Serienschaltungsanordnung (9) in Form des ersten Laststromanschlusses (C) des dritten Leistungshalbleiterschalters (T3) und der Ausgangsanschluss der zweiten Serienschaltungsanordnung (9) in Form der Kathode der zweiten Diode (D2) vorliegt.

3. 3-Level-Stromrichterhalbbrücke nach Anspruch 1, **dadurch gekennzeichnet, dass** der Eingangsanschluss der ersten Serienschaltungsanordnung (8) in Form der Anode der dritten Diode (D3) und der Ausgangsanschluss der ersten Serienschaltungsanordnung (8) in Form des zweiten Laststromanschlusses (E) des zweiten Leistungshalbleiterschalters (T2) vorliegt, wobei der Eingangsanschluss der zweiten Serienschaltungsanordnung (9) in Form der Anode der zweiten Diode (D2) und der Ausgangsanschluss der zweiten Serienschaltungsanordnung in Form des zweiten Laststromanschlusses (E) des dritten Leistungshalbleiterschalters (T3) vorliegt.
